Europäisches Patentamt

European Patent Office

Office européen des brevets

(19)

(11) Publication number: **0 268 426**
**A2**

## (12) EUROPEAN PATENT APPLICATION

(21) Application number: **87309999.8**

(22) Date of filing: **12.11.87**

(51) Int. Cl.⁴: **H01L 29/80**

(30) Priority: **17.11.86 US 931263**

(43) Date of publication of application:
**25.05.88 Bulletin 88/21**

(84) Designated Contracting States:
**AT BE CH DE ES FR GB GR IT LI LU NL SE**

(71) Applicant: **LINEAR TECHNOLOGY CORPORATION**
**1630 McCarthy Boulevard**
**Milpitas California 95035(US)**

(72) Inventor: **Khadder, Wadie N.**
**1414 Knowlton Drive**
**Sunnyvale California 94087(US)**
Inventor: **Vokac, James P.**
**726 West Remington Avenue**
**Sunnyvale California 94087(US)**
Inventor: **Dobkin, Robert Curtis**
**4106 Ashbrook Circle**
**San Jose California 95124(US)**

(74) Representative: **Horton, Andrew Robert Grant et al**
**BOULT, WADE & TENNANT 27 Furnival Street**
**London, EC4A 1PQ(GB)**

(54) **High speed junction field effect transistor for use in bipolar integrated circuits.**

(57) A high speed BIFET junction field effect transistor is formed in an epitaxial layer (10) of one conductivity type and includes source (18) and drain (20) regions of opposite conductivity type interconnected by a channel region (24) of the opposite conductivity type. A surface layer (26) of the one conductivity type is formed over the channel region, and a highly conductive contact (32) is formed on the surface layer intermediate the source and drain regions. The surface layer can include a region (30) beneath the contact of high dopant concentration of the one conductivity type. The surface contact (32) can comprise highly doped polycrystalline silicon material with or without a metal layer on the surface thereof. Alternatively, the surface contact (32) can comprise a barrier metal contacting the surface layer and a second metal overlying the barrier metal. The surface contact and the epitaxial layer underlying the channel region comprises gates for the field effect transistor. Increased speed of operation comes from the increased conductivity of the surface contact and the limited size and thus reduced capacitance of the surface contact.

PRIOR ART

FIG. — 3

## "HIGH SPEED JUNCTION FIELD EFFECT TRANSISTOR FOR USE IN BIPOLAR INTEGRATED CIRCUITS"

Background of the Invention

This invention relates generally to semiconductor transistor devices, and more particularly the invention relates to a high speed junction field effect transistor.

The use of junction field effect transistors (JFETs) in bipolar integrated circuits is known (BIFETs). One such transistor is disclosed in U.S. Patent No. 4,176,368. Operating speed is an important charcteristic of such a transistor. Heretofore, the BIFET structure has included top and bottom gates with the top gate comprising a lightly doped region above the transistor channel region and with the top and bottom gates electrically connected through the semiconductor structure. Patent No. 4,176,368 proposes a higher speed BIFET by forming a more heavily doped region in the lightly doped top gate between and separated from the source and drain regions of the transistor. The heavily doped region does reduce the gate conductance from 5-15 kilo-ohms per square to a range of 500-1500 ohms per square.

Summary of the Invention

The present invention is directed to an improved higher speed BIFET. Breifly, a highly doped gate contact is formed on the surface of the lightly doped top gate region between the source and drain regions. The gate contact is electrically separated from the bottom contact thereby permitting a four terminal device operation if desired. Additionally, the contact has limited surface area thereby presenting a small parasitic capacitance and minimum leakage current. Preferably, the contact comprises highly doped polycrystalline silicon. Alternatively, a barrier metal such as titanium-tungsten, molybdenum, or tungsten can be placed on the lightly doped top gate spaced from the source and drain regions. A metal contact such as aluminum for example can be placed on the surface of the polysilicon contact or the barrier metal to further reduce resistance.

The region of the lightly doped top gate layer beneath the polysilicon gate contact can be more heavily doped similar to the device disclosed in U.S. Patent number 4,176,368. Advantageously, the gate resistance in accordance with the invention can be reduced to on the order of 1-40 ohms per square as opposed to the 500-1500 ohms per square for the device disclosed in the '368 patent.

Accordingly, an object of the invention is an improved BIFET.

Another object of the invention is a BIFET having increased operating speed.

A feature of the invention is a BIFET having separate top and bottom gate contacts.

The invention and objects and features thereof will be more readily apparent from the following detailed description and dependent claims when taken with the drawing.

Brief Description of the Drawing

FIGURE 1 is a section view of a BIFET device in accordance with the prior art.

FIGURE 2 is a section view of another BIFET device in accordance with the prior art.

FIGURE 3 is a section view of a BIFET device in accordance with one embodiment of the present invention.

Detailed Description of Illustrated Embodiments

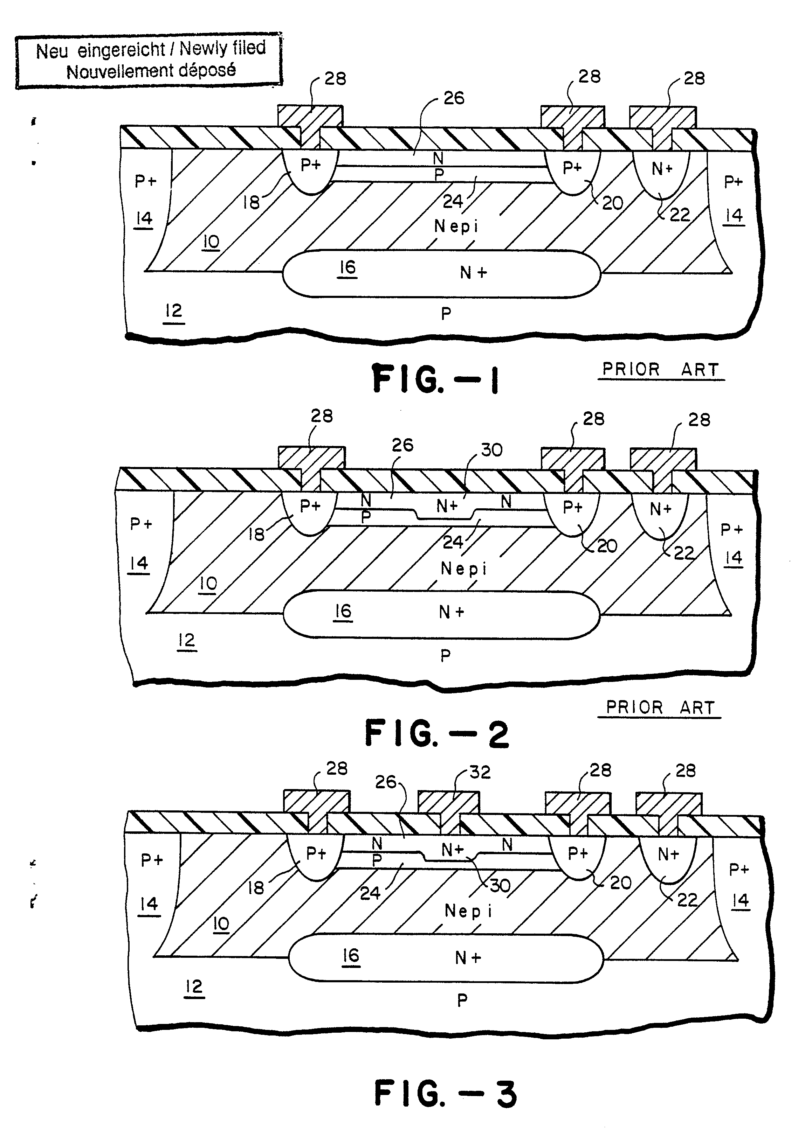

Referring now to the drawings, Figure 1 and Figure 2 are section views of prior art BIFET devices as disclosed in U.S. Patent number 4,176,368. In accordance with the device of Figure 1 an N-type epitaxial layer 10 is formed on a surface of P-type substrate 12 with a device region defined by P+ isolation regions 14. An N+ buried layer 16 is formed by doping a surface region of substrate 12 prior to the epitaxial growth of layer 10. The BIFET device is then formed in the device region of the epitaxial layer 10 with a source region 18 and drain region 20 formed by P+ dopants and a gate contact 22 is formed by N+ dopant. A P-type channel region 24 is formed between the source and drain region 18, 20, and a lightly doped top gate layer 26 is formed on the surface between the source and drain regions. The N-type top gate layer 26 is interconnected with the bottom gate contact defined by epitaxial layer 10 through the epitaxial structure. Metal contacts 28 are made to the source, drain and gate region.

In order to increase the speed of the device shown in Figure 1, the '368 patent proposes the structure disclosed in Figure 2. The same reference numbers are used for like elements. In this embodiment a region 30 in the lightly doped top gate contact region 26 is formed by the selective introduction of N-type dopants by ion implantation, for example. Again, the N+ region 30 is electrically interconnected with the bottom gate contact comprising epitaxial layer 10 through the epitaxial structure. Due to the increased conductance of N + layer 30 the gate resistance is reduced from approximately 5-15 kilo-ohms per square with the device of Figure 1 to 500-1500 ohms per square with the device of Figure 2. The reduction in gate resistance results in a significant increase in operating speed.

Figure 3 is a section view of a BIFET device in accordance with the present invention. Again, like elements have the same reference numerals as in Figures 1 and 2. In accordance with the invention a contact 32 is made to an intermediate portion of the lightly doped top layer 26, spaced from the source and drain region 18, 20. As illustrated in Figure 3 a highly doped region 30 is provided in the lightly doped gate layer 26 beneath the contact 32 as in the embodiment of Figure 2. However, the increased speed of operation of the device of Figure 3 depends primarily on the provision of the high conductance contact 32 and only secondarily on the provision of the highly doped region 30. Thus, the provision of region 30 is not essential to the invention.

In a preferred embodiment, the contact 32 comprises highly doped polycrystalline silicon. A metal layer 34 of aluminum, for example, can be provided on the top surface of contact 32 thereby increasing the conductance of the contact and further increasing the speed of operation. In alternative embodiments, a barrier metal such a titanium tungsten, molybdenum, or tungsten can be placed in direct contact with the lightly doped top gate layer 26 with a contact metal of aluminum, for example, formed on the surface of the barrier metal.

In each of the embodiments described above, the top gate contact is limited in surface area and can be isolated from the bottom gate contact thereby providing a four terminal device. The smaller area of the top gate reduces the parasitic capacitance and leakage current thereby further enhancing operation of the device.

The provision of a gate contact on the lightly doped top gate layer can reduce the top gate resistance to the order to 1 to 40 ohms per square. This low resistance coupled with the four terminal operation of the BIFET enhances the operating speed significantly over the prior art BIFET structures.

While the invention has been described with reference to a specific embodiments, the description is illustrative of the invention and not to be construed as limiting the invention. Various modifications and applications may be apparent by those skilled in the art without departing from the true spirit and scope of the invention as defined by the appended claims.

**Claims**

1. A field effect transistor comprising a semiconductor body region (10,12) of one conductivity type; first (18) and second (20) regions of opposite conductivity type formed in a surface of said body region and spaced from each other, said first and second regions forming a source and a drain of said transistor; a channel region (24) of said opposite conductivity type in said body region and interconnecting said first and second regions; and a surface region (26) of said one conductivity type overlying said channel region and extending from said first region to said second region, charcterised by a surface contact (32) on said surface region between said first and second regions, said surface contact having a conductivity greater than the conductivity of said surface layer, said body region beneath said channel region and said surface contact constituting electrically separate gates for said transistor.

2. A field effect transistor as defined by claim 1 wherein said surface contact (32) comprises polycrystalline silicon of said one conductivity type.

3. The field effect transistor as defined by claim 2 and further including a metal layer (34) on the surface of said polycrystalline silicone.

4. A field effect transistor as defined by claim 1 wherein said surface contact (32) comprises a diffusion barrier metal in contact with said surface region and a metal formed on the surface of said barrier metal.

5. A field effect transistor as defined by any foregoing claim and further including a third doped region (30) of said one conductivity type in said surface region beneath said surface contact, said third doped region having a dopant concentration greater than the dopant concentration of the remainder of said surface region.

6. A field effect transistor as defined by any foregoing claim wherein said semiconductor body region comprises an epitaxial layer (10), and further including a substrate (12) of said opposite conductivity type on which said epitaxial layer is formed.

7. A field effect transistor as defined by claim 6 and further including a buried layer (16) of said first conductivity type formed in said substrate at the interface of said epitaxial layer and positioned beneath said first and second regions.

8. A field effect transistor as defined by claim 6 or 7 and further including an isolation region (14) extending from the surface of said epitaxial layer to said substrate and surrounding said first and second regions.

9. A field effect transistor as defined by claim 8 wherein said isolation region (14) comprises doped semiconductor material.

10. The field effect transistor as defined by claim 8 wherein said isolation region (14) comprises semiconductor oxide.

11. A field effect transistor as defined by any of claims 6 to 10 and further including a fourth region (22) of said first conductivity type formed in the surface of said epitaxial layer for contacting said epitaxial layer.

12. A field effect transistor as defined by claim 11 and further including metal contacts (28) to said first region, said second region, and said fourth region.

**FIG. — 1**     PRIOR ART

PRIOR ART

**FIG. — 2**

**FIG. — 3**